# EUROPEAN PATENT APPLICATION

(11) **EP 4 611 492 A1**
(43) Date of publication of application: **03.09.2025**
(21) Application number: 25157321.8
(22) Date of filing: 12.02.2025
(51) Int. Cl.: H05K 3/00, H05K 3/46, H05K 1/18

(54) **COMPONENT CARRIER WITH CAVITY AND LASER PROTECTION STRUCTURE**

(30) Priority: 28.02.2024 CN 202410223545
(71) Applicant: AT & S Austria Technologie & Systemtechnik Aktiengesellschaft, 8700 Leoben-Hinterberg (AT)
(72) Inventor: PARK, Ho Sik, Chongqing, 401120 (CN); BAFTIRI, Artan, Chongqing, 401121 (CN); CHEN, Lonis, Chongqing, 401120 (CN)
(74) Representative: Donatello, Daniele

(57) **Abstract**

A component carrier (100), wherein the component carrier (100) comprises a stack (104) with at least one electrically conductive layer structure (106) and at least one electrically insulating layer structure (108), a cavity (110) formed in the stack (104) and being delimited by a bottom wall (112) and a sidewall (114), and an electrically conductive laser protection structure (102) at least in an edge region between the bottom wall (112) and the sidewall (114).

## Description

### Field of the Invention

The invention relates to a component carrier and to a method of manufacturing a component carrier.

### Technological Background

In the context of growing product functionalities of component carriers equipped with one or more components and increasing miniaturization of such components as well as a rising number of components to be connected to the component carriers such as printed circuit boards, increasingly more powerful array-like components or packages having several components are being employed, which have a plurality of contacts or connections, with ever smaller spacing between these contacts. In particular, component carriers shall be mechanically robust and electrically reliable so as to be operable even under harsh conditions.

### Summary of the Invention

There may be a need to form a component carrier with accurately defiance cavity and in a simple way.

According to an exemplary embodiment of the invention, a component carrier is provided which comprises a stack with at least one electrically conductive layer structure and at least one electrically insulating layer structure, a cavity formed in the stack and being delimited by a bottom wall and a sidewall, and an electrically conductive laser protection structure at least in an edge region between the bottom wall and the sidewall.

According to another exemplary embodiment of the invention, a method of manufacturing a component carrier is provided, wherein the method comprises providing a stack with at least one electrically conductive layer structure and at least one electrically insulating layer structure, forming a cavity in the stack, said cavity being delimited by a bottom wall and a sidewall, and forming an electrically conductive laser protection structure at least in an edge region between the bottom wall and the sidewall, wherein said laser protection structure may form part of the readily manufactured component carrier.

In the context of the present application, the term "component carrier" may particularly denote any support structure which is capable of accommodating one or more components thereon and/or therein for providing mechanical support and/or electrical connectivity and/or thermal connectivity. In other words, a component carrier may be configured as a mechanical and/or electronic and/or thermal carrier for components. A component carrier may comprise a laminated stack, such as a laminated layer stack. In particular, a component carrier may be one of a printed circuit board, an organic interposer, and an IC (integrated circuit) substrate. A component carrier may also be a hybrid board combining different ones of the above mentioned types of component carriers.

In the context of the present application, the term "stack" may particularly denote a flat or planar sheet-like body. For instance, the stack may be a layer stack, in particular a laminated layer stack or a laminate. Such a laminate may be formed by connecting a plurality of layer structures by the application of mechanical pressure and/or heat. Preferably, the plurality of layer structures are aligned parallel on top of each other. The stack may comprise at least one electrically conductive structure and at least one electrically insulating structure.

In the context of the present application, the term "layer structure" may particularly denote a continuous layer, a patterned layer or a plurality of nonconsecutive islands within a common plane, and it may perform the function of electrical conductivity and/or electrical insulation. In the context of the present application, the term "cavity" may particularly denote a blind hole or a through hole in the stack of the component carrier. For example, a cavity may be shaped and dimensioned for accommodating a component or another component carrier entirely or partially therein. Preferably, only one blind hole is formed in the stack

In the context of the present application, the term "electrically conductive laser protection structure" may particularly denote a physical structure made of a material which is less prone to removal by a laser beam than surrounding material, in particular material under the laser protection structure. For instance, the electrically conductive laser protection structure may be a metallic structure with lower absorption rate (in particular less than 5%) and/or higher reflection rate (in particular 90%-95%) of laser radiation than another (for example metallic, ceramic, glass, resin, etc.) material below the laser protection structure facing away from the laser beam. Even more specifically, the electrically conductive laser protection structure may be made of a metallic material having a lower absorption rate and/or a higher reflection rate of laser radiation than copper material. Preferred materials for the electrically conductive laser protection structure may be silver, aluminum, gold, nickel and/or chromium. For example when made of silver, the electrically conductive laser protection structure may also enhance a signal transmission since its electrical conductivity may be higher than that of copper.

In the context of the present application, the term "edge region between bottom wall and sidewall of cavity" may particularly denote a region delimiting the cavity and being arranged in an interface volume between the bottom wall and the sidewall of the cavity. For instance, the edge region may be or may comprise a corner region between bottom wall and sidewall of the cavity. For instance, the bottom wall of the cavity may denote a horizontal or substantially horizontal area delimiting the cavity from a bottom side. For example, the sidewall of a cavity may denote a vertical, substantially vertical or slanted area delimiting the cavity in a lateral direction. In between bottom wall and sidewall, the edge region may be located. The edge region may form a circumferentially closed or annular region. Alternatively, the edge region may comprise a plurality of portions, being free of interconnection with each other.

In the context of the present application, the term "main surface of a body" may particularly denote one or more largest substantially planar surface area(s) of the body (for instance the stack). Usually, for instance substantially cuboid bodies may have two opposing main surfaces in the form of two horizontal surface areas on top and on bottom of the body. Thus, the main surface may be different from the sidewalls of the body.

According to an exemplary embodiment of the invention, a component carrier (such as a printed circuit board (PCB) or an integrated circuit (IC) substrate) comprises a (for instance laminated) layer stack in which a cavity is formed. Advantageously, at least part of an electrically conductive laser protection structure is formed in or along an edge or corner region between a bottom wall and a sidewall delimiting said cavity. Such an electrically conductive laser protection structure may protect at least partially a structure below it, for instance an electrically conductive laser stop structure, against a laser beam which may be directed onto the stack for forming the cavity. For instance, the cavity may be formed by removing a piece from the stack which can be circumferentially defined by laser cutting, and from a bottom side for example by a poorly adhesive release layer. Just as an example, the laser protection structure may be a silver structure formed on top of a copper structure, as an example for a laser stop structure, to be protected against partial or entire removal by a laser beam which can be directed onto the stack and towards such a copper structure during forming the cavity. By providing an electrically conductive laser protection structure selectively at least in an edge or corner region between a bottom wall and sidewalls of the cavity to be formed, formation of very deep cavities by laser processing, requiring a strong laser impact, may be made possible without the risk of excessive damage of the stack due to the impact of the laser beam.

### Detailed Description of Exemplary Embodiments

In the following, further exemplary embodiments of the component carrier and the method will be explained.

In an embodiment, the component carrier comprises an electrically conductive laser stop structure covering at least part of said bottom wall and/or of said sidewall and being at least partially covered by said laser protection structure. In the context of the present application, the term "electrically conductive laser stop structure" may particularly denote a metallic structure below the laser protection structure which ensures that a laser beam used for forming the cavity does not cut deeper into the stack than up to or into the electrically conductive laser stop structure. In particular, the electrically conductive laser protection structure may be arranged between a laser source emitting said laser beam and the electrically conductive laser stop structure. For instance, the electrically conductive laser protection structure may be arranged between the cavity on its top side and the electrically conductive laser stop structure on its bottom side. While the electrically conductive laser protection structure may protect the electrically conductive laser stop structure from excessive damage by the laser beam, the electrically conductive laser stop structure may provide an extra safety feature for reliably preventing the laser beam from cutting into the stack up to a depth beneath the laser stop structure. For example, the laser protection structure may also be used to protect a beneath optical structure and/or radiofrequency waveguide structure.

In another embodiment, a separate laser stop structure, provided in addition to the laser protection structure, may be absent. In such an embodiment, there may be only a laser protection structure (for instance made of silver) but no additional laser stop structure (for example made of copper) below. For example, a silver layer may function both as laser protection structure and as stop layer.

In an embodiment, the laser stop structure forms part of the at least one electrically conductive layer structure of the stack. Hence, the laser stop structure may form an integral part of the stack, and may be made of the same material as at least one further electrically conductive layer structure of the stack, preferably copper.

In an embodiment, the laser protection structure can be a surface finish layer when it functions as interconnection layer to connect with a component and/or another electrical and/or optical element (for instance an optical plug). If said surface finish layer comprises silver, this may be provided for enhanced antioxidation with organic silver. When embodied as surface finish layer, the laser protection structure may comprise gold, for example NiPdAu or pure gold for good electrical performance.

In an embodiment, the laser stop structure and the laser protection structure are made of different materials. Said different materials may be different metals, different metal compositions, or different alloys. This may allow to adjust individually the properties of the laser protection structure and the laser stop structure in accordance with their respective task or function.

In an embodiment, the laser stop structure and the laser protection structure form a multilayer conductive structure. In particular, laser stop structure and laser protection structure may form a metallic stack of two different structures, in particular layers. It is also possible that the laser protection structure partially or entirely encapsulates the laser stop structure. Between layers of the multilayer conductive structure, an interface may be formed which additionally reduces the removal of material by the laser beam.

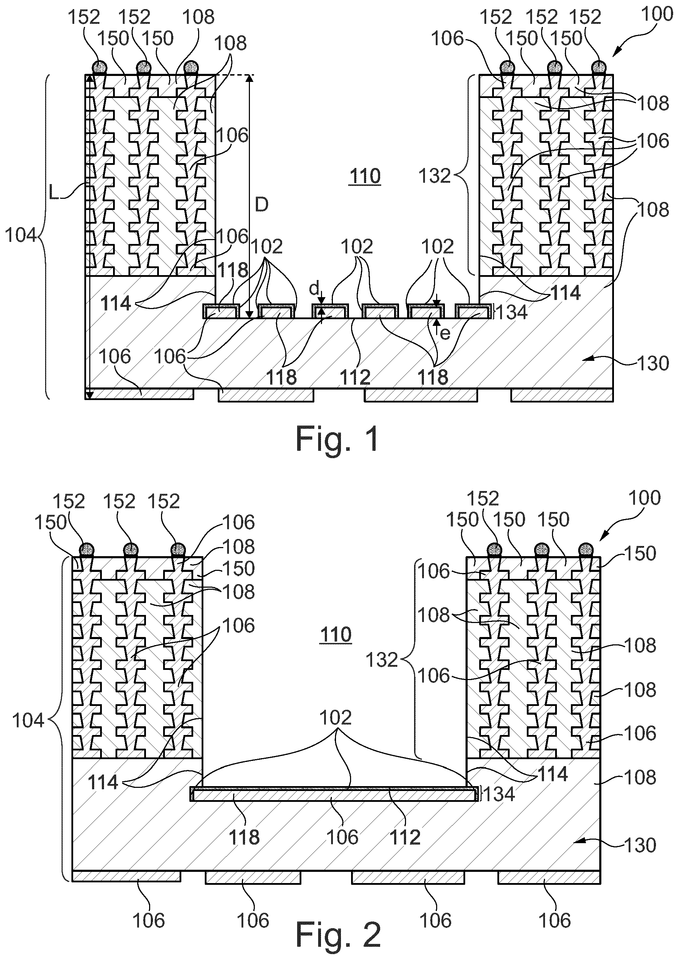

In an embodiment, a first portion of the multilayer conductive structure is exposed in the cavity and a second portion of the multilayer conductive structure is embedded in the stack. Such an embodiment, which is shown for instance in Figures 1, 16 to 18, reliably ensures that the laser beam cutting the cavity does not extend laterally beyond the multilayer conductive structure and does not cause artefacts around the edge between bottom wall and sidewall of the cavity. It is also possible to cut through the deep cavity (such as more than 700 µm or 800 µm) from the manufacturing point of view.

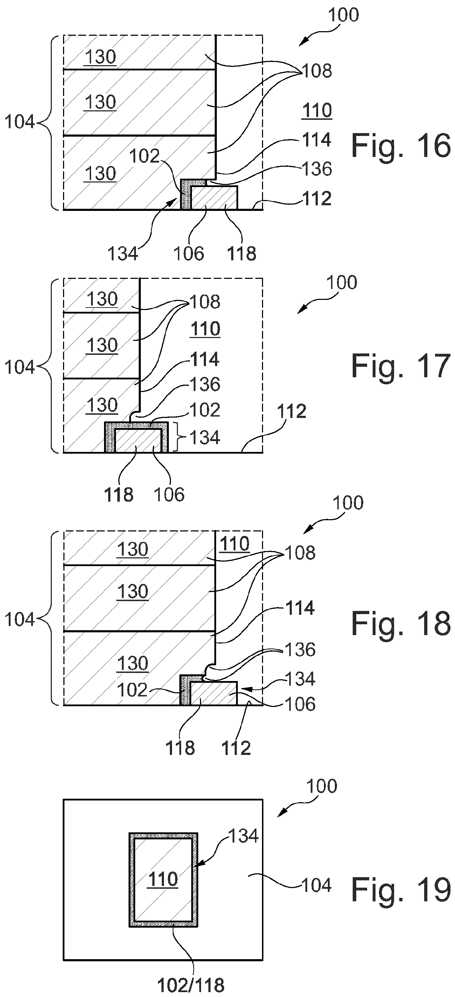

In an embodiment, the laser protection structure is arranged in the second portion, in particular is arranged only in the second portion. A corresponding embodiment is shown for instance in Figure 16. Such a configuration may be obtained for example when an exposed part of the laser protection structure is sacrificed during the cavity formation process using a laser beam for cutting and optionally a further material removal process, for example plasma etching and/or wet chemical etching.

In an embodiment, the laser protection structure is exposed at the sidewall delimiting the cavity (see Figure 16). Even if the laser protection structure is removed during laser processing in the first portion, it may still be exposed at the sidewall of the cavity. This may bring the advantage of providing good adhesion to the sidewall of the cavity due to the material properties of the laser protection structure and/or a provided undercut.

In an embodiment, the laser protection structure is present at least partially in the first portion. A corresponding embodiment is shown for instance in Figure 17. Such a structure may be obtained for example when the laser protection structure withstands the laser beam during a cavity formation process by laser cutting. At least a part of the laser protection structure may then extend into the cavity. Therefore, due to the treatment with a laser to the exposed portion, the surface of the exposed portion may have different roughness or morphology compared with the portion being not exposed. This increased roughness may improve the adhesion between the exposed laser protection structure and the other elements which will be connected with it. Meanwhile, this may bring the advantage of protecting the laser stop structure and/or electrically conductive layer structure from the environment, for example from decomposition by moisture and/or air.

In an embodiment, the laser protection structure is arranged to disable a direct physical contact between an upper main surface and/or a sidewall of the laser stop structure and the rest of the stack. For example, the laser protection structure may form a cap on the top surface and a lateral surface of the laser stop structure. This may bring the further advantage of ensuring reliable integrity of the laser stop structure in the stack, since the laser protection structure may have adhesion promotion properties.

In an embodiment, the first portion is free of the laser protection structure (see for instance Figure 16). This may allow to maintain the laser protection structure only where needed after cavity formation. For example, a portion of the laser protection structure being exposed to the cavity along its edge at a corner between bottom wall and sidewalls may also be consumed during laser processing. This may also lead to a different roughness of the laser protection structure surface due to laser treatment and non-treatment.

In an embodiment, the first portion comprises at least a portion of the laser protection structure (see for instance Figure 1 or Figure 17). In such an embodiment, the laser protection structure may permanently protect the laser stop structure in the cavity, for instance also against corrosion and/or physical impact.

In an embodiment, the laser protection structure forms at least part of the first portion and/or of the second portion. Thus, the laser protection structure may be present only in one of said portions, or in both. This may allow taking advantage of physical and/or chemical properties of the laser protection structure, for example durability, or electrically conductivity, and thus provides a high freedom of design of the component carrier. It may also have a different function with such kind of structure based on a certain application.

In an embodiment, an area (for instance a surface area of an upper main surface or a surface area facing away from the laser stop structure) of the electrically conductive laser protection structure is larger than an area of the bottom wall of the cavity in the stack (see for instance Figure 2). For example, an area of an upper main surface of the above mentioned multilayer conductive structure may be larger than an area of the bottom wall of the cavity in the stack. Such a large area of the laser protection structure or of the multilayer conductive structure may provide a protection against the laser beam over a large spatial range being even larger than the actual bottom surface of the cavity. This may provide a safety feature for the event of tolerances.

In an embodiment, the electrically conductive laser protection structure extends laterally beyond the bottom wall of the cavity in the stack (compare Figure 2). For example, an upper main surface of the multilayer conductive structure extends laterally beyond the bottom wall of the cavity in the stack. When the laser protection structure, and optionally also a laser stop structure, extend(s) laterally beyond the limits of the cavity into the stack, a particular reliable protection of a cutting laser beam from extending into undesired regions of the stack may be provided. When the laser beam cuts the portions of stack down to the laser protection structure, the cutting may not be straight and totally smooth for the whole sidewall area, it may cause some damage on the sidewall area. The damage may be an over etch of material and/or an undercut of cavity bottom areas. Due to the laser protection structure extending into the stack, even if there is over etch or undercut, the laser beam may extend only down to the laser protection structure and will not cause damage on the layer below with the laser protection structure protecting the layer below.

In an embodiment, the electrically conductive laser protection structure is a continuous layer (see Figure 2), in particular covering the entire bottom wall of the stack. For example, the multilayer conductive structure comprising the laser protection structure and a laser stop structure may be a continuous layer, in particular covering the entire bottom wall of the stack. In such a configuration, the whole bottom wall of the cavity in the stack may be reliably protected against the laser beam which ensures the formation of a deep and accurate cavity. Additionally, the laser protection structure can be functionalized as heat dissipation structure when there is a component or multiple components embedded in the cavity for a package. In particular, the component or package may be for high performance computing.

In an embodiment, the electrically conductive laser protection structure is a patterned structure (see for instance Figure 1), in particular only partially covering the bottom wall of the cavity in the stack. For example, the multilayer conductive structure may be a patterned layer, in particular only partially covering the bottom wall of the stack. Such a configuration keeps the space and material consumption for forming the laser protection structure and optionally a laser stop structure small. It can provide the electrical connection and signal transmission.

In an embodiment, the sidewall has an undercut between the stack and the electrically conductive laser protection structure (compare Figure 16 to Figure 18). For example, the sidewall has an undercut between the stack and the multilayer conductive structure. In case of a multilayer structure, an undercut can be formed between two layer structures thereof. Such an undercut may be created during laser formation of the cavity, which may also remove part of the laser protection structure, this may lead to an undercut.

In an embodiment, the electrically conductive laser protection structure is formed on a core of the stack, in particular between the core and a layer build-up of the stack. For example, the multilayer conductive structure comprising laser protection structure and laser stop structure is formed on a core of the stack, in particular between the core and a layer build-up of the stack. Thanks to the provision of the laser protection structure, a cavity forming laser beam may cut through a layer build-up into a core beneath the build-up without the risk of artifact formation. This may allow to create even very deep cavities extending up to or even into a core.

In an embodiment, the electrically conductive laser protection structure is formed in and/or on a multilayer core of the stack. For example, the multilayer conductive structure comprising laser stop structure and laser protection structure may be formed in and/or on a multilayer core of the stack. Hence, even a stack comprising a plurality of core layers may be subjected to a cavity formation by laser processing without the risk of damage or inaccuracies of the formed cavity.

In an embodiment, the electrically conductive laser protection structure is formed in and/or on a layer build-up of the stack. Thus, the described embodiment may allow cavity formation in a layer build-up, a corresponding component carrier may even be coreless. This may bring the advantage of including the laser protection structure into a dedicated layer. Since a layer in the layer build up may be thinner than 100 µm, even thinner than 50 µm, a well-defined cavity may be produced in terms of cavity thickness.

In an embodiment, the cavity formed in the stack extends through the build-up of one side of a core and through the core down to a build-up on the other side of the core. Therefore, the laser protection structure may be formed on the other build-up. With such a structure, the cavity may be very deep and the component carrier can be firstly formed with symmetric structure. Additionally, this may also allow to control warpage, as there may be a need for a high layer count on one side for the deep cavity. It may be possible to balance the layer count and cavity depth. What is more, this may also provide the flexibility to have a high density or lower density for the component carrier based on the final application.

In an embodiment, the cavity extends vertically over a plurality of layer structures of the stack. For instance, said plurality of layer structures over which the cavity extends vertically may be at least two, in particular at least three, preferably at least four, or even more than four, for instance at least ten. A corresponding deep cavity without structural artefacts may be formed in particular by using a pulsed laser source, for instance having a pulse length of not more than picoseconds, in particular not more than femtoseconds.

In an embodiment, the cavity has a depth of at least 500 µm, in particular of at least 700 µm. In an embodiment, the cavity has a depth of at least 50% of a thickness of the stack. Advantageously, such a large cavity depth may be capable of supporting a number of high-tech applications, for instance an optical package comprising at least one optical component embedded in the cavity.

In an embodiment, the laser protection structure comprises a plurality of connected sublayers, in particular made of different materials and/or of different material compositions. The properties of the laser protection structure in terms of protecting the stack (for instance a laser stop structure of the stack) against the impact of a laser beam may be further refined by configuring the laser protection structure from two or more individual sublayers or substructures of different metals, metal compositions or alloys. This may enhance reflectivity and/or may reduce an absorption rate of the multilayer laser protection structure with respect to laser light.

In an embodiment, the method comprises making the laser protection structure of a material having, in relation to an operation wavelength of the laser beam, an absorption rate below 0.2 (or 20%) and/or a reflectivity of at least 0.7 (or 70%). In an embodiment, the laser protection structure is made of a material configured for reflecting laser light. For example, at least 60%, preferably at least 70%, more preferably at least 80%, of the laser light may be reflected by the laser protection structure. A preferred choice may be that the material can absorb less than 5% of the light, and reflect and/or disperse more than 95% of the light. Advantageously, the laser protection structure may be made of a material configured for absorbing only a very small amount of laser light. For instance, the laser protection structure may have an absorption rate with respect to the laser light of not more than 40%, preferably not more than 20%, most preferably of not more than 10%. When the laser protection structure strongly reflects and/or poorly absorbs laser light, precisely defined and very deep cavities may be formed without the risk of pronounced artefacts. Also, a laser stop structure may be reliably protected by the laser protection structure.

In an embodiment, the laser protection structure is made of a material having a higher reflectivity of laser light than copper. At appropriate laser wavelengths, silver, aluminum, gold and/or chromium may be good choices for the material of the laser protection structure.

In an embodiment, the laser protection structure comprises or consists of silver and/or aluminium and/or an alloy comprising silver and/or aluminium, gold and/or an alloy. These materials are perfectly compatible with requirements for component carrier stacks and may simultaneously provide a reliable protection against laser light.

In an embodiment, the laser stop structure comprises or consists of copper. Hence, the laser stop structure covered at least partially by the laser protection structure may be made of copper material being perfectly compatible with component carrier manufacturing technology, for instance for manufacturing PCBs or IC substrates.

In an embodiment, the laser protection structure and/or the laser stop structure forms an annularly closed frame, in particular extending entirely along said edge region. A corner may be formed between the bottom wall and the sidewall of the cavity. A circumferentially closed edge may be formed by said corner extending along the entire perimeter of the bottom wall of the cavity. When forming the laser protection structure, and optionally a laser stop structure, along said entire circumferentially closed edge, the whole edge is protected during laser processing by the laser protection structure. This may ensure excellent results in terms of cavity accuracy, damage suppression and/or cavity depth.

In an embodiment, the laser protection structure and/or the laser stop structure is non-functional, in particular in terms of an electric and/or an optical functionality of the component carrier. A non-functional laser protection structure, and optionally a non-functional laser stop structure, may denote the fact that the laser protection structure and/or the laser stop structure does not have any electrical and/or optical function during operation of the component carrier. The only purpose of such a laser protection structure and/or laser stop structure may be a protection and/or stop of a laser beam during cutting the cavity. For instance, laser protection structure and/or laser stop structure may be unconnected to the other electrically conductive layer structures of the stack.

In an embodiment, the laser stop structure forms an electrically conductive pattern covering a part of said bottom wall and exposing another part of said bottom wall (see for instance Figure 1). This may allow also a sidewall coverage of an electrically conductive laser stop structure by the laser protection structure, and thus a further enhanced protection effect.

In an embodiment, the laser protection structure covers the entire upper main surface of the electrically conductive pattern, and optionally covers sidewalls of the electrically conductive pattern. Such an embodiment is shown in Figure 1. In such an embodiment, an excellent protection against the laser beam is possible over a large portion of the bottom wall.

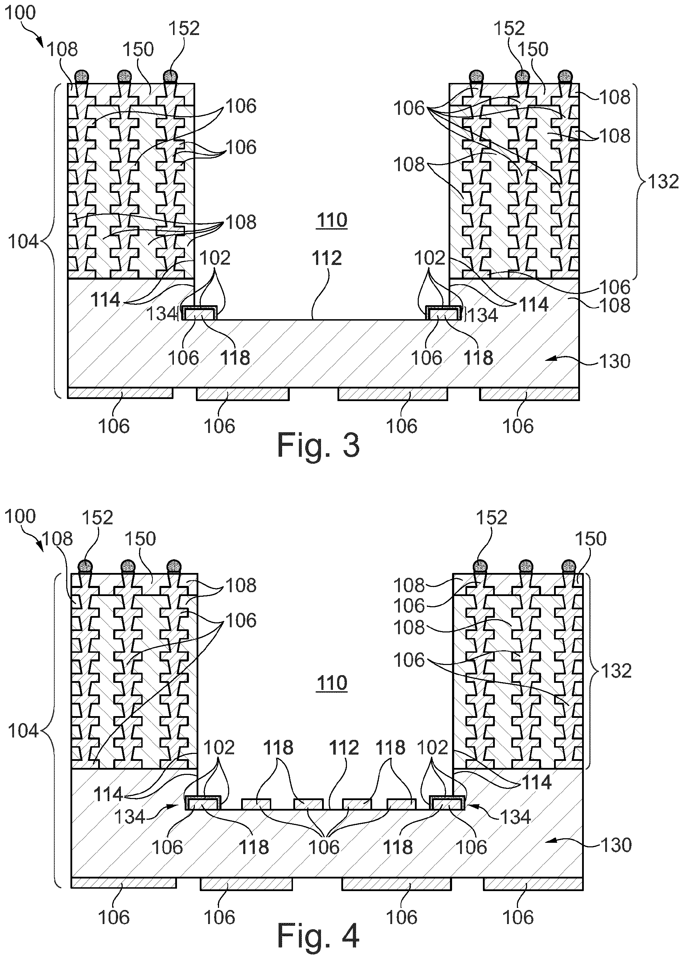

In an embodiment, the laser protection structure covers only the upper main surface of the electrically conductive pattern in the edge region and another area may be etched, and optionally covers additionally only sidewalls of the electrically conductive pattern in the edge region. Such an embodiment is shown in Figure 4. This may reduce the effort for producing the laser protection structure.

In an embodiment, the electrically conductive pattern is formed on the bottom wall and in the edge region of said cavity (see Figure 1 or Figure 4). This may provide a laser stop function over a large area.

In an embodiment, the electrically conductive pattern is formed only in the edge region of said cavity but not in a central portion of the bottom wall surrounded by said edge region. Such an embodiment is shown in Figure 3. This may bring the advantage of a large cavity volume and a low effort for forming the laser stop structure and the laser protection structure.

In an embodiment, the laser stop structure covers the entire bottom wall of the cavity (see Figure 2). Such an embodiment may provide a laser stop function over the entire extension of the bottom wall of the cavity and thus may ensure that a big area, for example bigger than 5000 µm², are protected by a damage using a laser beam.

In an embodiment, the electrically conductive laser protection structure covers the entire upper main surface of the laser stop structure, and optionally covers sidewalls of the laser stop structure. This may allow to achieve a very pronounced laser protection function. For example, the laser protection structure may cover at least the entire upper main surface of the laser stop structure covering the entire bottom wall of the cavity.

In an embodiment, the stack comprises a core and a layer build-up on said core, wherein the cavity extends through the entire layer build-up and partially into said core. Thanks to the provision of the laser protection structure, preferably in combination with a laser stop structure below, very deep cavities (for example having a depth of at least 500 µm, preferably at least 700 µm) may be formed without the risk of artefacts or damages of stack material due to the impact of a picosecond laser beam. Such a large cavity depth may also allow to cut the cavity through a complete layer build-up so as to extend also into a core below the layer-build-up.

In an embodiment, the cavity may be cut at the edge of the stack . Consequently, there may be only three sidewalls, and there may be a side with a lateral opening. With such kind of structure, an external connection element may be easily inserted, connected and/or disconnected with the component carrier (such as an optical plug and/or an unplug element).

In an embodiment, the component carrier comprises at least one component, in particular an optical connector, inserted at least partially in at least part of said cavity. In the context of the present application, the term "component inserted at least partially in at least part of said cavity" may particularly denote a component being fully accommodated or only partially accommodated in the cavity in the stack. In a fully accommodated embodiment, the entire vertical spatial range between upper end and lower end of the component is located inside of the cavity. In a partially accommodated embodiment, only part of a vertical spatial range between upper end and lower end of the component is located inside of the cavity, for instance the component may protrude upwardly and/or downwardly beyond the cavity. In one embodiment, the upper end of the at least partially accommodated component may be in alignment with an upper main surface of the stack and/or the lower end of the component may be in alignment with a lower main surface of the stack. For instance, the component may be an electrical component for providing an electrical function (such as a semiconductor chip), a thermal component for providing a cooling function (such as a copper or ceramic block) and/or an optical component providing an optical function. Said optical component may for instance be an optical chip or an optical connector. In particular, such an optical chip may be a chip configured for receiving an optical signal, and more particularly for converting the received optical signal into an electric signal by an electrooptical converter (such as a photodiode). The optical chip may also have processing capability for processing an optical signal and/or an electric signal to or from which the optical signal can be derived by the optical chip. The optical chip may be an electro-optical chip, in particular providing an optical functionality of an electro-optical system. In particular, the optical chip may also have an integrated semiconductor laser diode and/or an amplifier. In an embodiment, the component may be a waveguide connector, for instance being optically coupled with an optical waveguide. For example, the optical connector may be an optical fiber connector. Such an optical fiber connector may be an optical member which joins an optical fiber, and enables quick connection and disconnection. The cavity may be formed at the edge of the stack, and the cavity may be for a plug and unplug interface of optical cable.

In an embodiment, a thickness of the electrically conductive laser protection structure is in a range from 0.1 µm to 10 µm. In particular, the laser protection structure of the mentioned thickness may be made of silver. A corresponding laser stop structure, which may be made for example from copper, may have a thickness in a range from 10 µm to 50 µm. The combination of the mentioned individual thicknesses may be the total thickness of the above mentioned multilayer structure.

In an embodiment, a roughness Ra of the electrically conductive laser protection structure is in a range from 100 nm to 900 nm, in particular from 100 nm to 300 nm. In an embodiment, a roughness Ra of the electrically conductive laser stop structure is in a range from 150 nm to 1000 nm, in particular from 150 nm to 500 nm. Hence, the laser protection structure may be smoother or may have a lower roughness Ra than the laser stop structure to thereby further increase the reflectivity of the laser protection structure with respect to laser light and thus may be less prone to ablation by the layer beam/irradiation. The laser protection structure with laser beam treatment at the edge of the cavity may lead to different roughness from the laser protection structure at the central area or other area without the laser beam treatment. The laser protection structure at the edge of the cavity may have bigger roughness than the laser protection structure at another area.

In an embodiment, the method comprises forming the cavity by processing the stack with a laser beam during which the laser protection structure protects against the laser beam a layer structure of the stack, in particular an electrically conductive laser stop structure arranged on the bottom wall of the cavity. Hence, during laser cutting of the cavity, more specifically sidewalls thereof, the laser protection structure may protect the stack, more specifically the laser stop structure, and the optional laser stop structure may protect the rest of the stack since it may reliably stop the laser beam even a part thereof passing through the laser protection structure.

In an embodiment, the method comprises making the laser protection structure of a material having, in relation to an operation wavelength of the laser beam, an absorption rate below 0.2 and/or a reflectivity of at least 0.7. This may allow to reflect a major portion of the light, whereas another portion of absorbed light may be small enough to avoid overheating and/or significant damage.

In an embodiment, the method comprises forming the cavity by processing with a pulsed laser beam. Preferably, the method comprises forming the pulsed laser beam with laser light pulses having a temporal length and/or a temporal distance of not more than 1 ps. For example, a picosecond laser or femtosecond laser may be used for forming the cavity. For instance, the method comprises forming the cavity by processing with a laser beam having a wavelength below 600 nm, for example in a range from 500 nm to 550 nm, such as 532 nm. A laser beam with the described properties may allow to form the cavity without executing a cumbersome desmear process.

In an embodiment, the method comprises forming a poorly adhesive release structure at least partially on the laser protection structure in an interior of the stack, separating a piece of the stack above the release structure by forming, in particular by laser processing, a circumferential separation trench around said piece, and removing said separated piece and said release structure from the rest of the stack. According to an exemplary embodiment, the cavity may be formed in the stack by embedding a release layer with poorly adhesive properties in the stack. For example, such a release layer may be made of a waxy material or of polytetrafluoroethylene (PTFE). Thereafter, a circumferentially closed cut may be created in the stack which cuts out a stack piece being delimited at a bottom surface by the release layer. Such a cutting process may be carried out, for instance, by laser cutting. After taking out the separated stack piece from the remainder of the stack, the cavity remains.

In an embodiment, the component carrier is shaped as a plate. This contributes to the compact design, wherein the component carrier nevertheless provides a large basis for mounting components thereon. Furthermore, in particular a naked die as example for an embedded electronic component, can be conveniently embedded, thanks to its small thickness, into a thin plate such as a printed circuit board.

In an embodiment, the component carrier is configured as one of the group consisting of a printed circuit board, a substrate (in particular an IC substrate), and an interposer.

In the context of the present application, the term "printed circuit board" (PCB) may particularly denote a plate-shaped component carrier which is formed by laminating several electrically conductive layer structures with several electrically insulating layer structures, for instance by applying pressure and/or by the supply of thermal energy. As preferred materials for PCB technology, the electrically conductive layer structures are made of copper, whereas the electrically insulating layer structures may comprise resin and/or glass fibers, so-called prepreg or FR4 material. The various electrically conductive layer structures may be connected to one another in a desired way by forming holes through the laminate, for instance by laser drilling or mechanical drilling, and by partially or fully filling them with electrically conductive material (in particular copper), thereby forming vias or any other through-hole connections. The filled hole either connects the whole stack, (through-hole connections extending through several layers or the entire stack), or the filled hole connects at least two electrically conductive layers, called via. Similarly, optical interconnections can be formed through individual layers of the stack in order to receive an electro-optical circuit board (EOCB). Apart from one or more components which may be embedded in a printed circuit board, a printed circuit board is usually configured for accommodating one or more components on one or both opposing surfaces of the plate-shaped printed circuit board. They may be connected to the respective main surface by soldering. A dielectric part of a PCB may be composed of resin with reinforcing fibers (such as glass fibers).

In an embodiment, the component carrier is an integrated circuit substrate. In the context of the present application, the term "integrated circuit substrate" (IC substrate) may particularly denote a component carrier having a size and a pitch adjusted to the requirements of an integrated circuit component (in particular the control chip) mounted thereon. An IC substrate may be a, in relation to a PCB, comparably small component carrier onto which one or more integrated circuit components may be mounted and that may act as a connection body between one or more chip(s) and a PCB. For instance, an IC substrate may have substantially the same size as an electronic component to be mounted thereon (for instance in case of a Chip Scale Package (CSP)). In another embodiment, the IC substrate may be larger than the assigned component (for instance in a flip chip ball grid array, FCBGA, configuration). More specifically, an IC substrate can be understood as a carrier for electrical connections or electrical networks as well as component carrier comparable to a printed circuit board (PCB), however with a considerably higher density of laterally and/or vertically arranged connections. Lateral connections are for example conductive paths, whereas vertical connections may be for example drill holes. These lateral and/or vertical connections are arranged within the IC substrate and can be used to provide electrical, thermal and/or mechanical connections of housed components or unhoused components (such as bare dies), particularly of IC chips, with a printed circuit board or interposer. A dielectric part of an IC substrate may be composed of resin with reinforcing particles (such as reinforcing spheres, in particular glass spheres). A pitch, i.e. a distance between corresponding edges of two adjacent metal structures, of an IC substrate may be not more than 150 µm, in particular not more than 100 µm. In contrast to this, a pitch of a PCB may be at least 200 µm, in particular at least 300 µm.

The substrate or interposer may comprise or consist of at least a layer of glass, silicon (Si) and/or a photoimageable or dry-etchable organic material like epoxy-based build-up material (such as epoxy-based build-up film) or polymer compounds (which may or may not include photo- and/or thermosensitive molecules) like polyimide or polybenzoxazole.

In an embodiment, the at least one electrically insulating layer structure comprises at least one of the group consisting of a resin or a polymer, such as epoxy resin, cyanate ester resin, benzocyclobutene resin, bismaleimide-triazine resin, polyphenylene derivate (e.g. based on polyphenylenether, PPE), polyimide (PI), polyamide (PA), liquid crystal polymer (LCP), polytetrafluoroethylene (PTFE) and/or a combination thereof. Reinforcing structures such as webs, fibers, spheres or other kinds of filler particles, for example made of glass (multilayer glass) in order to form a composite, could be used as well. A semi-cured resin in combination with a reinforcing agent, e.g. fibers impregnated with the above-mentioned resins is called prepreg. These prepregs are often named after their properties e.g. FR4 or FR5, which describe their flame retardant properties. Although prepreg particularly FR4 are usually preferred for rigid PCBs, other materials, in particular epoxy-based build-up materials (such as build-up films) or photoimageable dielectric materials, may be used as well. For high frequency applications, highfrequency materials such as polytetrafluoroethylene, liquid crystal polymer and/or cyanate ester resins, may be preferred. Besides these polymers, low temperature cofired ceramics (LTCC) or other low, very low or ultra-low DK materials may be applied in the component carrier as electrically insulating structures.

In an embodiment, the at least one electrically conductive layer structure comprises at least one of the group consisting of copper, aluminum, nickel, silver, gold, palladium, tungsten, magnesium, carbon, (in particular doped) silicon, titanium, and platinum. Although copper is usually preferred, other materials or coated versions thereof are possible as well, in particular coated with supra-conductive material or conductive polymers, such as graphene or poly(3,4-ethylenedioxythiophene) (PEDOT), respectively.

At least one further component may be embedded in and/or surface mounted on the stack. The component and/or the at least one further component can be selected from a group consisting of an electrically nonconductive inlay, an electrically conductive inlay (such as a metal inlay, preferably comprising copper or aluminum), a heat transfer unit (for example a heat pipe), a light guiding element (for example an optical waveguide or a light conductor connection), an electronic component, or combinations thereof. An inlay can be for instance a metal block, with or without an insulating material coating (IMS-inlay), which could be either embedded or surface mounted for the purpose of facilitating heat dissipation. Suitable materials are defined according to their thermal conductivity, which should be at least 2 W/mK. Such materials are often based, but not limited to metals, metal-oxides and/or ceramics as for instance copper, aluminium oxide (Al₂O₃) or aluminum nitride (AIN). In order to increase the heat exchange capacity, other geometries with increased surface area are frequently used as well. Furthermore, a component can be an active electronic component (having at least one p-n-junction implemented), a passive electronic component such as a resistor, an inductance, or capacitor, an electronic chip, a storage device (for instance a DRAM or another data memory), a filter, an integrated circuit (such as field-programmable gate array (FPGA), programmable array logic (PAL), generic array logic (GAL) and complex programmable logic devices (CPLDs)), a signal processing component, a power management component (such as a field-effect transistor (FET), metal-oxide-semiconductor field-effect transistor (MOSFET), complementary metal-oxide-semiconductor (CMOS), junction field-effect transistor (JFET), or insulated-gate field-effect transistor (IGFET), all based on semiconductor materials such as silicon carbide (SiC), gallium arsenide (GaAs), gallium nitride (GaN), gallium oxide (GazOs), indium gallium arsenide (InGaAs), indium phosphide (InP) and/or any other suitable inorganic compound), an optoelectronic interface element, a light emitting diode, a photocoupler, a voltage converter (for example a DC/DC converter or an AC/DC converter), a cryptographic component, a transmitter and/or receiver, an electromechanical transducer, a sensor, an actuator, a microelectromechanical system (MEMS), a microprocessor, a capacitor, a resistor, an inductance, a battery, a switch, a camera, an antenna, a logic chip, and an energy harvesting unit. However, other components may be embedded in the component carrier. For example, a magnetic element can be used as a component. Such a magnetic element may be a permanent magnetic element (such as a ferromagnetic element, an antiferromagnetic element, a multiferroic element or a ferrimagnetic element, for instance a ferrite core) or may be a paramagnetic element. However, the component may also be an IC substrate, an interposer or a further component carrier, for example in a board-in-board configuration. The component may be surface mounted on the component carrier and/or may be embedded in an interior thereof. Moreover, also other components, in particular those which generate and emit electromagnetic radiation and/or are sensitive with regard to electromagnetic radiation propagating from an environment, may be used as component.

In an embodiment, the component carrier is a laminate-type component carrier. In such an embodiment, the component carrier is a compound of multiple layer structures which are stacked and connected together by applying a pressing force and/or heat.

After processing interior layer structures of the component carrier, it is possible to cover (in particular by lamination) one or both opposing main surfaces of the processed layer structures symmetrically or asymmetrically with one or more further electrically insulating layer structures and/or electrically conductive layer structures. In other words, a build-up may be continued until a desired number of layers is obtained.

After having completed formation of a stack of electrically insulating layer structures and electrically conductive layer structures, it is possible to proceed with a surface treatment of the obtained layers structures or component carrier.

In particular, an electrically insulating solder resist may be applied to one or both opposing main surfaces of the layer stack or component carrier in terms of surface treatment. For instance, it is possible to form such a solder resist on an entire main surface and to subsequently pattern the layer of solder resist so as to expose one or more electrically conductive surface portions which shall be used for electrically coupling the component carrier to an electronic periphery. The surface portions of the component carrier remaining covered with solder resist may be efficiently protected against oxidation or corrosion, in particular surface portions containing copper.

It is also possible to apply a surface finish selectively to exposed electrically conductive surface portions of the component carrier in terms of surface treatment. Such a surface finish may be an electrically conductive cover material on exposed electrically conductive layer structures (such as pads, conductive tracks, etc., in particular comprising or consisting of copper) on a surface of a component carrier. If such exposed electrically conductive layer structures are left unprotected, then the exposed electrically conductive component carrier material (in particular copper) might oxidize, making the component carrier less reliable. A surface finish may then be formed for instance as an interface between a surface mounted component and the component carrier. The surface finish has the function to protect the exposed electrically conductive layer structures (in particular copper circuitry) and enable a joining process with one or more components, for instance by soldering. Examples for appropriate materials for a surface finish are Organic Solderability Preservative (OSP), Electroless Nickel Immersion Gold (ENIG), Electroless Nickel Immersion Palladium Immersion Gold (ENIPIG), Electroless Nickel Electroless Palladium Immersion Gold (ENEPIG), gold (in particular hard gold), chemical tin (chemical and electroplated), nickel-gold, nickel-palladium, etc. Also nickel-free materials for a surface finish may be used, in particular for high-speed applications. Examples are ISIG (Immersion Silver Immersion Gold), and EPAG (Eletroless Palladium Autocatalytic Gold).

The aspects defined above and further aspects of the invention are apparent from the examples of embodiment to be described hereinafter and are explained with reference to these examples of embodiment.
Figure 1 illustrates a cross-sectional view of a component carrier according to an exemplary embodiment of the invention.
Figure 2 illustrates a cross-sectional view of a component carrier according to another exemplary embodiment of the invention.
Figure 3 illustrates a cross-sectional view of a component carrier according to another exemplary embodiment of the invention.
Figure 4 illustrates a cross-sectional view of a component carrier according to another exemplary embodiment of the invention.
Figure 5 illustrates a cross-sectional view of a preform of a component carrier according to another exemplary embodiment of the invention.
Figure 6 to Figure 11 show cross-sectional views of structures obtained during carrying out a method of manufacturing a component carrier according to an exemplary embodiment of the invention.
Figure 12 is a flowchart of a method of manufacturing a component carrier according to an exemplary embodiment of the invention.
Figure 13 to Figure 15 show cross-sectional views of structures obtained during carrying out a method of manufacturing a component carrier according to an exemplary embodiment of the invention.
Figure 16 illustrates a cross-sectional view of a detail of a component carrier according to another exemplary embodiment of the invention.
Figure 17 illustrates a cross-sectional view of a detail of a component carrier according to another exemplary embodiment of the invention.
Figure 18 illustrates a cross-sectional view of a detail of a component carrier according to another exemplary embodiment of the invention.
Figure 19 illustrates a plan view of a component carrier according to another exemplary embodiment of the invention.
Figure 20 is a diagram showing a dependency between a wavelength of laser light and an absorption rate for different materials.

The illustrations in the drawings are schematic. In different drawings, similar or identical elements are provided with the same reference signs.

Before, referring to the drawings, exemplary embodiments will be described in further detail, some basic considerations will be summarized based on which exemplary embodiments of the invention have been developed.

In the field of heterogeneous packaging, integration and co-packaging, there may be a need for deeper cavities. Conventionally, a cavity depth in a stack of a component carrier may be lower than 300 µm. However, if the cavity depth increases for example above 700 µm, a laser beam used for forming the cavity may go up to a core inside directly. Generally, there may be different kinds of lasers which can be used for different applications. Considering the different pulse, different power and different wavelengths of different lasers, different depths of the cavity may be chosen by selecting an appropriate one of different lasers. For a cavity of 300 µm or deeper, a pico laser may be applied due to the characteristics that a shot of the laser can be generated in picoseconds, therefore the power is very strong to break the chemical bonding of substance and then the wavelength can go through very deep to cut out the material. In particular, a picosecond laser beam can damage copper of the stack during formation of the cavity. However, the copper layer which should not be cut may absorb the power from the picosecond laser to be damaged. Therefore, a laser protection layer may be advantageous.

According to an exemplary embodiment of the invention, a component carrier (for example a PCB or an IC substrate) is provided with a stack of preferably laminated layers having one or more (preferably blind hole-type) cavities therein. An electrically conductive laser protection structure may be arranged at least in an edge region between a bottom wall and a sidewall delimiting said cavity. Preferably but not necessarily, said laser protection structure may comprise a circumferentially closed frame structure extending along the entire perimeter of the interface between bottom wall and sidewall of the cavity. The laser protection structure may suppress or may completely avoid damage of an electrically conductive laser stop structure or other stack material under the laser protection structure against a laser beam. For example, such a laser beam may be emitted onto the stack during formation of the cavity. A lateral extension of the cavity may be defined by such a laser beam. For instance, the laser protection structure may comprise silver formed on or above a copper structure to be protected against removal or excessive damage by said laser beam. Lower absorption and/or higher reflection of laser light by the laser protection structure in comparison with the laser stop structure may allow the formation of deep cavities by a laser beam while simultaneously protecting efficiently the laser stop structure against the intense laser beam. Additionally, even a deep cavity with a depth of more than 300 µm, or more than 500 µm or even more than 700 µm can be formed with good accuracy (taper may be controlled and the alignment can be also good).

In particular, the electrically conductive laser protection structure may be designed preferably as a silver surface finish capable of protecting stop layer copper thereunder. Alternatively, the electrically conductive laser protection structure may comprise aluminium, gold, chromium, titanium, tungsten, platinum or an alloy thereof. The provision of such an electrically conductive laser protection structure may allow to use a picosecond laser (for example having a wavelength of 532 nm) to replace a conventional CO₂ laser (which may however also be used in other embodiments). Alternatively, an excimer laser, for example having a wavelength of one of the group of 157 nm, 193 nm, 248 nm, 308 nm, 351 nm, or a carbon monoxide laser may be used. Advantageously, the use of a picosecond laser may avoid an undesired desmear process to be executed after laser cutting as the picosecond laser will not generate much heat which might burn the resin and cause carbonization of a sidewall of the cavity in the stack. Exemplary embodiments of the invention may make possible to manufacture a cavity with higher depth, which may even extend partially through a core. The electrically conductive laser protection structure, which may be made of silver, may protect an electrically conductive laser stop layer, which may be made of copper, against a laser beam with picosecond laser implementation. Alternatively, the laser stop layer may comprise electrically insulating material, for example ceramic, glass or an organic polymer material. Further alternatively, the laser stop layer may comprise a paste having a polymeric matrix and a plurality of metallic nanoparticles dispersed in the matrix. The homogeneously dispensed nanoparticles may have the same effect to react with a laser beam as a metallic layer. In an example, the electrically conductive laser stop layer may comprise aluminium, gold, palladium, platinum, chromium, tungsten or an alloy thereof. In particular, a surface finish comprising silver and being applied on stop layer copper may be used advantageously for protecting the latter against the laser beam. This may make it possible to manufacture a cavity of different depth values, for instance up to a depth of 700 µm or more. Advantageously, this may be accompanied by an improved functional stability of the obtained component carrier.

Hence, exemplary embodiments of the invention may support applications which require precise machining with low heat affected zone. Picosecond and femtosecond lasers that may use laser sources with lower wavelength may be used for this purpose and may provide the advantage that desmear process post machining may be dispensable, and that deeper targets may be reachable. The provision of an electrically conductive laser protection structure, preferably comprising silver or aluminium, may make cavity formation with picosecond or femtosecond lasers possible without the risk of excessive damage of the stack during cavity formation by laser processing.

Hence, cutting quality and laser stop layer integrity may be improved by using a picosecond or even shorter pulse laser in combination with a laser protection structure comprising silver or another metallic material of similar laser reflectance to stop the laser beam, for instance before the laser beam damages an electrically conductive laser stop structure below the electrically conductive laser protection structure. More specifically, exemplary embodiments may apply a silver layer as a laser protection layer onto a circuit inside the cavity when executing a laser manufacturing process to form a cavity. The silver, or alternatively an aluminium layer, may be applied by physical vapor deposition, chemical vapor deposition or wet chemical reaction, for example electroless plating. Thus, it may be possible to apply a laser stop structure with a laser protection structure embodied as silver circuits disposed thereon in a cavity. By applying silver on a laser stop structure comprising copper (in particular at cavity edges), it may be possible to protect stop copper during laser processing. This may improve machining in substrates for heterogeneous packaging.

To achieve the aforementioned and/or other advantages, it may be possible to provide a component carrier which comprises a stack comprising at least one electrically conductive layer structure and at least one electrically insulating layer structure, a cavity formed in the stack, delimited by a bottom surface and at least one lateral surface (or sidewall), wherein said lateral surface may be delimited by a laser protection structure of a multilayer conductive structure.

The multilayer conductive structure may comprise at least two layer structures, including one conductive layer structure corresponding at least partially to at least one electrically conductive layer structure composing the stack. Said conductive layer structure may be made of copper. Furthermore, said conductive layer structure may form a laser stop structure. Moreover, a further conductive layer structure of the multilayer conductive structure may cover at least partially the aforementioned one conductive layer structure. Said further conductive layer structure may form a laser protection structure. Said further conductive layer structure may be made of a material different from the aforementioned one conductive layer structure, in particular may be made of at least one of silver and aluminum. Said further conductive layer structure may comprise multiple layers, which may in particular be made of different materials or a material composition (such as an alloy). Preferably, a first portion of the multilayer conductive structure may be exposed to the cavity and a second portion of the multilayer conductive structure may be embedded in the stack. For instance, the further conductive layer structure is provided in the second portion. In an embodiment, the further conductive layer structure is laterally exposed at the lateral wall of the cavity. Preferably, this may result in a concave shape and/or in an undercut (for instance due to a removal of the exposed further conductive layer structure). For example, the contact between the one conductive layer structure and the adjacent (for instance lateral) layer structure of the stack may be prevented by the further conductive layer structure. One possible effect of this measure may be copper migration prevention. The first portion may be free of the further conductive layer structure. Alternatively, also the first portion at least partially comprises the further conductive layer structure. The first portion may comprise residues of the further conductive layer structure. The further conductive layer structure may be at least partially provided in one or both of the portions. In an embodiment, the planar extension of the multilayer conductive structure at least partially, in particular entirely, extends beyond the planar extension of the cavity. The multilayer conductive structure may comprise a frame structure at least partially, in particular entirely, following the perimeter of the lateral wall. The multilayer conductive structure may comprise a continuous layer, in particular covering the whole bottom surface of the cavity. Alternatively, the multilayer conductive structure may comprise a patterned layer, in particular partially covering part of the bottom surface of the cavity. In an embodiment, the cavity extends along a plurality of layer structures of the stack. For example, an undercut along the vertical direction is provided between the lateral wall of the cavity and the multilayer conductive structure. For example, the multilayer conductive structure is provided on a core, in particular between the core and one build-up structure. In an embodiment, the multilayer conductive structure is provided in a layer composing the core structure (which may for instance be embodied as a multilayer core). For example, the multilayer conductive structure is provided in the build-up layers. In an embodiment, the cavity has a thickness greater than half of the component carrier thickness. For example, the cavity extends along the core thickness, and the multilayer conductive layer structure is provided on the build-up layer structure defining the bottom of the cavity. Advantageously, a cavity with a depth in a range from 700 µm to 800 µm may be formed. Cutting may be done by a picosecond laser, or by another tool. A wavelength from the cutting tool may impact the material removal properties.

Regarding the correlation between material and wavelength, generally laser light can be absorbed, reflected, refracted, dispersed by a material, etc. Preferred materials for the laser protection structure are those that do not absorb excessively but also do not transmit an excessive amount of light for the specific light source (which has a characteristic wavelength). If a material absorbs an excessive amount of laser light, it may burn. If a material transmits an excessive amount of laser light, it may burn below the material (which may lead to a damage of the material underneath). Thus, a metallic material may be preferred for the laser protection structure which has no or low absorption and no or low transmission of laser light. For that reason, a good choice as a material for the laser protection structure may be silver, but aluminum or gold may be possible as well.

An exemplary application of exemplary embodiments of the component carrier may be an optical package, which may for instance be formed in accordance with silicon photonics technology. In particular, an optical component, i.e. a component with optical functionality (such as an optical connector), may be embedded in the cavity of the component carrier.

**Figure 1** illustrates a cross-sectional view of a component carrier 100 according to an exemplary embodiment of the invention.

Component carrier 100 may be an integrated circuit (IC) substrate or a printed circuit board (PCB). The component carrier 100 may comprise a laminated layer stack 104 comprising electrically conductive layer structures 106 and electrically insulating layer structures 108. For example, the electrically conductive layer structures 106 may comprise patterned metal layers (such as patterned copper foils or patterned deposited copper layers) and vertical through connections, for example copper filled vias, which may be created by drilling and plating. The electrically insulating layer structures 108 may comprise a respective resin (such as a respective epoxy resin), preferably comprising reinforcing particles therein (for instance glass fibers or glass spheres). For example, the electrically insulating layer structures 108 may be made of prepreg or FR4 or ABF. The electrically insulating layer structures 108 may also comprise resin layers being free of glass (in particular glass fibers).

As shown in Figure 1, the uppermost electrically insulating layer structure 108 may be embodied as a patterned solder resist 150 exposing selective portions of the uppermost electrically conductive layer structure 106. On said exposed portions of the uppermost electrically conductive layer structure 106, solder structures 152 may be formed. Solder structures 152 may allow to establish a solder connection of component carrier 100 with an electronic environment, for instance with at least one surface-mounted component and/or with another electronic board.

The stack 104 comprises a fully cured core 130 at a bottom side and a multilayer build-up 132 formed on the core 130.

As shown, a cavity 110 is formed in the stack 104. In the shown embodiment, the cavity 110 is a blind hole which extends through the entire build-up 132 into a part of the core 130. The cavity 110 is delimited at its bottom side by a bottom wall 112 and laterally by a circumferential sidewall 114. The cavity 110 has a large depth, D, of for example 700 µm or more. As shown, the cavity 110 extends vertically over a plurality of layer structures 106, 108 of the stack 104, partially through the core 130 and entirely through the layer build-up 132. In the shown embodiment, depth D of the cavity 110 is more than 50% of a thickness L of the stack 104. This large depth D allows embedding of an optical connector (not shown) into the cavity 110.

Moreover, an electrically conductive laser protection structure 102 is formed in and along an entire circumferential (not shown in Figure 1) edge region at a circumferential corner between the bottom wall 112 and the sidewall 114. Advantageously, the laser protection structure 102 and a laser stop structure 118 under the laser protection structure 102 may form an annular closed frame extending along said entire edge region. The laser protection structure 102 and the laser stop structure 118 may provide a laser protection and laser stop function along the entire perimeter of the bottom-sidewall transition of the cavity 110. In addition to the edge region, the electrically conductive laser protection structure 102 and the electrically conductive laser stop region 118 are present also in part of a central portion of the bottom wall 112 surrounded by the circumferential edge region.

The laser protection structure 102 is made of a material, preferably silver, which is capable of protecting a portion of the stack 104 below the laser protection structure 102 as well as the laser stop structure 118 below the laser protection structure 102 against the impact of a laser beam used for forming cavity 110. This protection may be accomplished by reflecting a large majority of the laser light and by absorbing only a small minority of the laser light by the laser protection structure 102.

As already mentioned, the electrically conductive laser stop structure 118 may be present below the laser protection structure 102 and may be configured for stopping the laser beam used for forming cavity 110, even after having partially passed through the laser protection structure 102. This protects the stack material beneath the laser stop structure 118 against an undesired impact by the laser beam and may therefore prevent stack damage and may ensure mechanical integrity of the portion of stack 102 delimiting cavity 110. As shown, the laser stop structure 118 covers part of said bottom wall 112 and part of said sidewall 114 and is covered, in turn, by said laser protection structure 102. In the shown embodiment, the laser stop structure 118 forms part of the electrically conductive layer structures 106 of the stack 104 and can thus be made of copper.

By forming the laser stop structure 118 from copper and the laser protection structure 102 from silver and/or aluminium and/or gold, i.e. of different materials, an individual material selection is possible for optimizing separately the respective laser stop and laser protection functions.

As shown, the laser stop structure 118 and the laser protection structure 102 form a multilayer conductive structure 134. The multilayer conductive structure 134 is here embodied as a double-layer, but may also be a layer composed of more than two sublayers or substructures. As shown as well, a first portion of the multilayer conductive structure 134 is exposed in the cavity 110 and a second portion of the multilayer conductive structure 134 is embedded in the stack 104. This arrangement ensures cavity formation with excellent mechanical integrity even in the case of tolerances, for instance in terms of laser alignment with respect to stack 104. According to Figure 1, a part of the laser stop structure 118 and a part of the laser protection structure 102 are arranged in the first portion, and another part of the laser stop structure 118 as well as another part of the laser protection structure 102 are arranged in the second portion.

In the shown embodiment, the laser protection structure 102 comprises caps covering top portions as well as sidewalls portions of each individual substructure of the patterned layer forming the laser stop structure 118. As a result, the laser protection structure 102 is arranged to disable a direct physical contact between, on the one hand, an upper main surface and a sidewall of the laser stop structure 118 and, on the other hand, the rest of the stack 104. Since each of the laser stop structure 118 and the electrically conductive laser protection structure 102 is a patterned structure, the multilayer conductive structure 134 formed by structures 102, 118 only partially covers the bottom wall 112 of the stack 104, whereas another part of the bottom wall 102 is exposed beyond the multilayer conductive structure 134. Thus, the laser stop structure 118 forms an electrically conductive pattern covering a part of said bottom wall 112 and exposing another part of said bottom wall 112. The laser protection structure 102 covers the entire upper main surface of this electrically conductive pattern and covers the entire sidewalls of this electrically conductive pattern. As shown, said electrically conductive pattern is formed in a central portion of the bottom wall 112 and in the edge region of said cavity 110 surrounding said central portion. Both the laser stop structure 118 and the laser protection structure 102 are formed on the core 130 of the stack 104 below an interface between the core 130 and the layer build-up 132 of the stack 104.

In the shown embodiment, the laser protection structure 102 and the laser stop structure 118 are non-functional in the component carrier 100, i.e. do not contribute to the functionality provided during operation of the component carrier 100. The sole purpose of the multilayer conductive structure 134 may thus be providing a laser protection and laser stop function during the laser process executed for cavity formation. Consequently, the laser protection structure 102 and the laser stop structure 118 may also be electrically disconnected from the other electrically conductive layer structures 106 of stack 104, the latter contributing to the electronic functionality of component carrier 100. However, in another embodiment, the laser protection structure 102 and/or the laser stop structure 118 may simultaneously fulfil a function during operation of the component carrier 100, for instance an electric function in cooperation with the other electrically conductive layer structures 106. It may provide more electrically conductive elements as interconnection structure for the electrical connection requirement and it may have more input and output structures when there will be components or other electrical structures required to connect with those laser protection structures. As shown in Figure 1, a thickness d of the electrically conductive laser protection structure 102 may be in a range from 0.1 µm to 10 µm. Alternatively, the thickness d of the electrically conductive laser protection structure 102 may be in a range from 10 µm to 30 µm. Moreover, a thickness e of the electrically conductive laser stop structure 118 may be in a range from 2 µm to 70 µm, in particular in a range from 10 µm to 50 µm. More generally, laser stop structure 118 may have a larger thickness than laser protection structure 102. A roughness Ra of the electrically conductive laser protection structure 102 may be preferably in a range from 50 nm to 800 nm, in particular a range from 100 nm to 300 nm, whereas a roughness Ra of the electrically conductive laser stop structure 118 may be preferably in a range from 100 nm to 900 nm, in particular in a range from 150 nm to 500 nm. Thus, the surface of the laser protection structure 102 may be smoother or may have a lower roughness Ra than the surface of the laser stop structure 118. This may further promote reflection of a large majority of the laser light from the exposed main surface of the laser protection structure 102.

**Figure 2** illustrates a cross-sectional view of a component carrier 100 according to another exemplary embodiment of the invention.

The embodiment of Figure 2 differs from the embodiment of Figure 1 in particular in that, according to Figure 2, an upper main surface area of the electrically conductive laser protection structure 102 as well as an upper main surface area of the laser stop structure 118 is larger than a surface area of the bottom wall 112 of cavity 110 in the stack 104. As shown in Figure 2, each of the electrically conductive laser protection structure 102 and the electrically conductive laser stop structure 118 extends laterally beyond the bottom wall 112 of cavity 110 in the stack 104. According to Figure 2, each of the electrically conductive laser protection structure 102 and the electrically conductive laser stop structure 118 is a continuous layer extending over and beyond the entire bottom wall 112 of the cavity 110 in stack 104. Since the laser protection structure 102 and the laser stop structure 118 are full layers, no portion of bottom wall 112 is exposed according to Figure 2. The embodiment of Figure 2 provides an excellent reliability during laser processing. In Figure 2, the top surface as well as the sidewalls of the laser stop structure 118 are covered by the laser protection structure 102. Alternatively, only the top surface of the laser stop structure 118 may be covered by the laser protection structure 102. The laser protection structure 102 and the laser stop structure 118 can be configured for functioning as a heat dissipation layer or/and a power transmission layer.

**Figure 3** illustrates a cross-sectional view of a component carrier 100 according to another exemplary embodiment of the invention.

The embodiment of Figure 3 differs from the embodiment of Figure 1 in particular in that, according to Figure 3, the electrically conductive pattern of the multilayer conductive structure 134 composed of laser protection structure 102 and laser stop structure 118 is formed only in the circumferential edge region of said cavity 110 but not in a central portion of the bottom wall 112 surrounded by said edge region. In this embodiment, said multilayer conductive structure 134 consists only of a circumferentially closed frame structure covering the entire perimeter of the circumferential edge between bottom wall 112 and sidewall 114 of the cavity 102. Alternatively, the laser protection structure 102 and optionally the laser stop structure 118 may be interrupted (for instance like a ring having an opening). The embodiment of Figure 3 ensures a very large cavity volume while simultaneously providing a reliable protection and stop function for a cutting laser beam.

**Figure 4** illustrates a cross-sectional view of a component carrier 100 according to another exemplary embodiment of the invention.

The embodiment of Figure 4 differs from the embodiment of Figure 1 in particular in that, according to Figure 4, the laser protection structure 102 covers only the upper main surface and the sidewalls of the electrically conductive pattern forming the laser stop structure 118 in the edge region. Alternatively, only a portion of the sidewalls and/or a portion of the upper main surface of the electrically conductive pattern of the laser stop structure 118 located of the edge region may be covered by the laser protection structure 102. In the central portion of the bottom wall 112, a portion of said bottom wall 112 is exposed and another portion of said bottom wall 112 is covered by laser stop structure 118 only, the latter not being covered by laser protection structure 102 in said central region.

In a preferred embodiment, only the portion of the laser stop structure 118 of the central region may be configured as functional traces, for example to transmit signals, whereas another portion of the laser stop structure 118 in the edge portion may not have a function in the readily manufactured component carrier. Alternatively, it may be vice versa, i.e. the central portion may have no function, and the edge region may be functional. In yet another alternative, either no portion or all portions of the laser stop structures 118 may have a function.

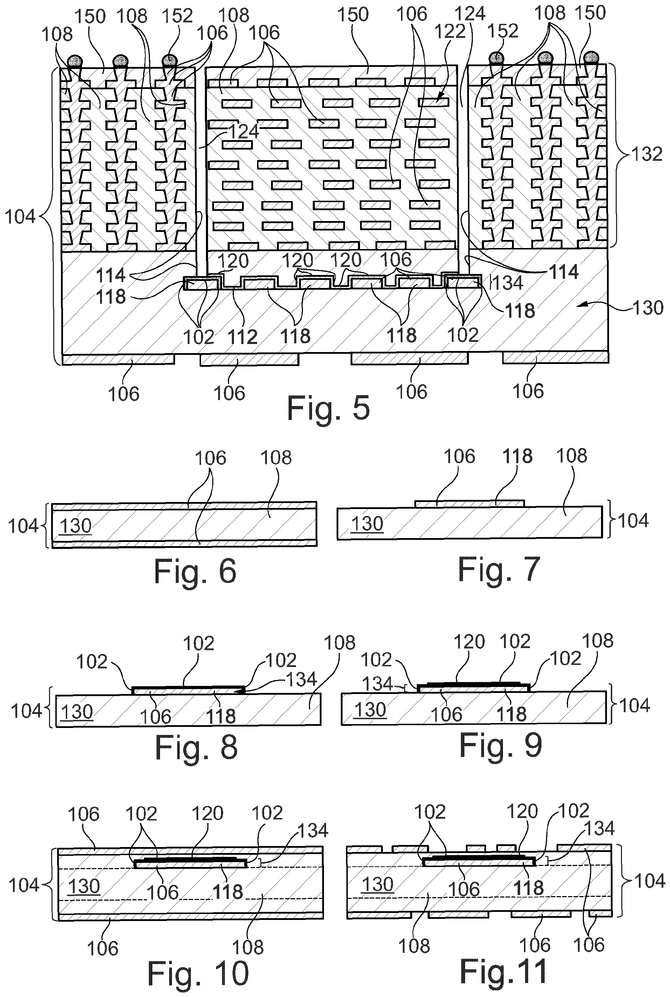

**Figure 5** illustrates a cross-sectional view of a preform of a component carrier 100 according to another exemplary embodiment of the invention. On the basis of Figure 5, the component carrier 100 of Figure 4 can be manufactured.

During this manufacturing process, laminated layer stack 104 with electrically conductive layer structures 106 and electrically insulating layer structures 108 may be formed. Cavity 110 may be formed in the stack 104, said cavity 110 being delimited by bottom wall 112 and sidewall 114. The manufacturing process may also encompass the formation of electrically conductive laser protection structure 102 exclusively in an edge region between the bottom wall 112 and the sidewall 114. The laser protection structure 102 may or may not form part of the readily manufactured component carrier 100. The laser protection structure 102 is formed on an edge portion of a patterned copper layer forming electrically conductive laser stop structure 118.

For forming the cavity 110, the stack 104 may be processed with a laser beam during which the laser protection structure 102 protects against the laser beam layer structures 106, 108 of the stack 104 including electrically conductive laser stop structure 118 of the electrically conductive layer structures 106 arranged on the bottom wall 112 of the cavity 110. Advantageously, the laser protection structure 102 may be made of a material such as silver having, in relation to an operation wavelength of the laser beam of for example 500 nm to 550 nm, an absorption rate below 0.2 and a reflectivity of at least 0.7, in particular an absorption below 0.05, a reflectivity and/or dispersion above 0.95 . Advantageously, the cavity 110 may be formed by processing stack 104 with a pulsed laser beam having laser light pulses with a temporal length and/or a temporal distance of not more than 1 ps. In particular, a picosecond laser or a femtosecond laser may be used.

More precisely, the structure shown in Figure 5 may be obtained by forming a poorly adhesive release structure 120 on an exposed lateral part the laser protection structure 102 and on an exposed central part of the laser stop structure 118. For example, the poorly adhesive release structure 120 may be made of polytetrafluoroethylene (PTFE). The structure composed of the poorly adhesive release structure 120, the laser stop structure 118 and the laser protection structure 102 may be arranged in an interior of the stack 104 by attaching (for instance laminating) a plurality of layer structures 106, 108 thereon. Thereafter, a piece 122 of the stack 104 above the release structure 120 may be removed by forming by laser processing a circumferential separation trench 124 around an entire perimeter of said piece 122. After this, said separated piece 122 and said release structure 120 may be removed from the rest of the stack 104. Since piece 122 is laterally separated by laser-cut trench 124 and only poorly adheres to the rest of stack 104 at a bottom side thanks to the release structure 120, piece 122 may be simply taken out from stack 104 leaving cavity 110 behind. Release structure 120 may be stripped or removed by etching. As a result, the component carrier 100 according to Figure 4 is obtained.

If the laser stop structure 118 was present without laser protection structure 102 in the edge region between bottom wall 112 and sidewall 114, exposed copper in said edge region would be prone to be destroyed by laser power when circumferentially delimiting cavity 110 by laser cutting, in particular when a cavity 110 of very large depth is to be formed. However, by providing a silver protection for the stop copper in the edge region in form of laser protection structure 102 on a lateral portion of laser stop structure 118, the silver protection on the stop layer copper may serve for providing a reliable protection of the laser stop structure 118 against damage by the laser beam.

Advantageously, the described manufacturing process may be capable of forming a cavity depth above 700 µm without the risk of damage by laser beam. In order to achieve this, deep cavity stop layer inside multiple layer core may be covered in the critical edge region by silver for protection purposes.

A skilled person will understand that the embodiments of Figure 1 to Figure 3 may be manufactured by a manufacturing process being similar to the one described referring to Figure 5 and Figure 4.

Figure 6 to Figure 11 show cross-sectional views of structures obtained during carrying out a method of manufacturing a component carrier 100 according to an exemplary embodiment of the invention.

Referring to **Figure 6****,** dielectric core 130 (for instance formed of FR4 material) may be covered on both opposing main surfaces thereof with metal layer-type electrically conductive layer structures 106 (for example copper foils). The obtained stack 104 may for instance be embodied as copper clad laminate (CCL).

Referring to **Figure 7****,** the upper electrically conductive layer structure 106 may be patterned for forming laser stop structure 118. The lower electrically conductive layer structure 106 may be removed. The described process may be embodied as a core imaging process.

Referring to **Figure 8****,** the exposed surface of the laser stop structure 118 may be covered by a laser protection structure 102 made of silver. This process may involve plating and/or physical vapor deposition and/or chemical vapor deposition. As a result, a surface finish silver layer forming laser protection structure 102 may be obtained.

Referring to **Figure 9****,** release structure 120 may be formed as a layer of poorly adhesive material (such as PTFE) covering a central portion of the laser protection structure 102. For instance, this process may be embodied as release ink printing and curing.

Referring to **Figure 10****,** release structure 120 may be optionally processed, for instance by laser trimming. Moreover, a multilayer core lamination process may be carried out during which layer structures 106, 108 may be attached to both opposing main surfaces of the structure shown in Figure 9. For instance, said structures 106, 108 may be prepreg sheets or resin sheets and copper foils.

Referring to **Figure 11****,** electrically conductive layer structures 106 on the main surfaces of the structure shown in Figure 10 may be optionally thickened and may be patterned.

Thereafter, an even thicker layer build-up structure may be formed, see for example reference sign 132 in Figure 5. Thereafter, cavity 110 may be formed by a process described above referring to Figure 5, i.e. laser cutting and piece removal.

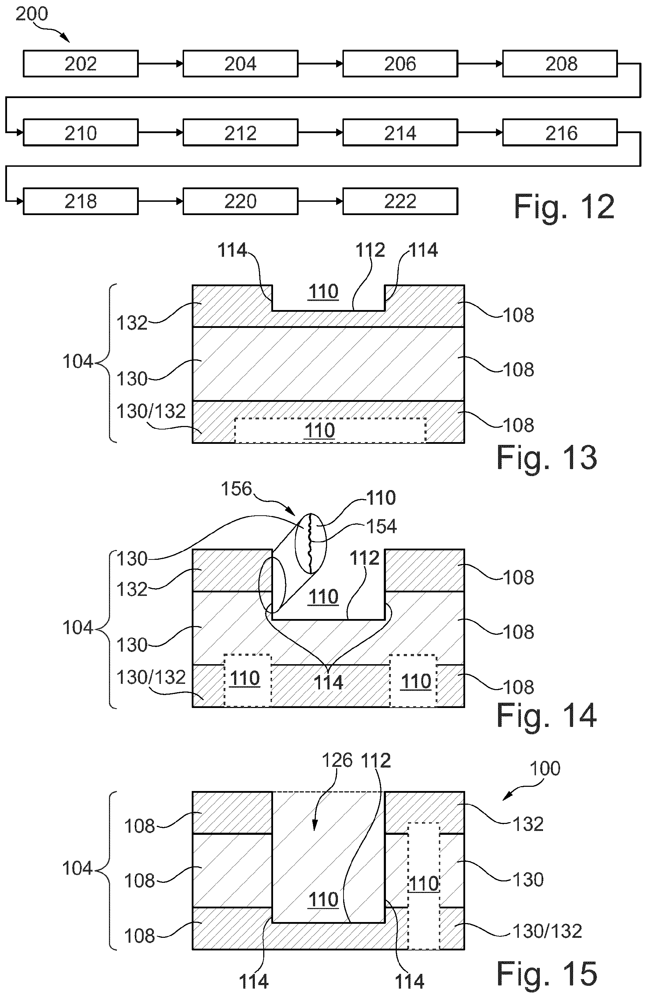

**Figure 12** is a flowchart 200 of a method of manufacturing a component carrier 100 according to an exemplary embodiment of the invention.

As shown in a block 202, a CCL core may be provided.

As shown in a block 204, the CCL core may be subjected to core imaging.

As shown in a block 206, a core plating process may be carried out.

As shown in a block 208, a surface finish silver layer may be formed.

As shown in a block 210, a core ink printing process may be executed.

As shown in a block 212, a multilayer core may be formed.

As shown in a block 214, a build-up manufacturing process may be executed.

As shown in a block 216, laser cutting may be performed for cavity formation.

As shown in a block 218, piece or cap removal may then be carried out.

As shown in a block 220, an ink stripping process may be executed.

As shown in a block 222, the manufacturing process ends.

Figure 13 to Figure 15 show cross-sectional views of structures obtained during carrying out a method of manufacturing a component carrier 100 according to an exemplary embodiment of the invention.

The preform of component carrier 100 of **Figure 13** has a central core 130 with a layer build-up 132 thereon. Below central core 130, a further core 130 may be arranged, or a further layer build-up 132.

As shown in Figure 13, cavity 110 is formed in upper layer build-up 132 only.

As shown in **Figure 14****,** formation of cavity 110 may be extended into the central core 130. Considering different absorption rates and reflectivity rates regarding different materials of stack 104, the high reflectivity of the laser beam from the low absorption material may slightly damage the sidewall 114 of the stack 104 when the laser light reflects. This might cause a wave structure 154 on the sidewall 114, see detail 156.

As shown in **Figure 15****,** the laser cutting process for manufacturing cavity 110 may even extend into the lower core 134 or the lower layer build-up 132. Such a deep cavity 110 may allow to embed a component 126 therein, for instance an optical connector.

Furthermore, as indicated with dotted lines in Figure 13 to Figure 15, it is possible that a plurality of cavities 110 are formed in stack 104. For instance, these can be multiple cavities 110 at different vertical levels, as in Figure 13. This can also be multiple cavities 110 arranged side-by-side, as in Figure 14. Also vertically displaced but vertically overlapping cavities 110 are possible, as in Figure 15. More generally, it may be possible to form a plurality of cavities 110 at different depths, with different widths and/or with different length. Different cavities may also be applied on opposite sides of stack 104.

**Figure 16** illustrates a cross-sectional view of a detail of a component carrier 100 according to another exemplary embodiment of the invention.

According to Figure 16, stack 104 may be formed for instance of a plurality of stacked cores 130 (wherein alternatively also a layer build-up 132 may be possible, not shown in Figure 16). As shown in Figure 16, the sidewall 114 of the stack 104 has an undercut 136 at an interface between the stack 104 and the electrically conductive laser protection structure 102. Undercut 136 may have a concave shape and may be formed by a partial removal of the exposed laser protection structure 102 due to the impact of the laser beam and/or an etching solution.

**Figure 17** illustrates a cross-sectional view of a detail of a component carrier 100 according to another exemplary embodiment of the invention.

The embodiment of Figure 17 differs from the embodiment of Figure 16 in particular in that, according to Figure 17, an exposed portion of laser protection structure 102 in cavity 110 remains entirely intact, and an undercut 136 is formed in stack 104 directly above laser protection structure 102. Also in Figure 17, undercut 136 has a concave shape. The obtained structure may be the result of the removed temporary ink layer (see reference sign 120 in the above-described embodiments) but not the further conductive layer structure according to reference sign 102. The undercut 136 is arranged along the vertical direction between the lateral sidewall 114 of the cavity 110 and the multilayer conductive structure 134 composed of laser stop structure 118 and laser protection structure 102.

**Figure 18** illustrates a cross-sectional view of a detail of a component carrier 100 according to another exemplary embodiment of the invention.

The embodiment of Figure 18 differs from the embodiments of Figure 16 and Figure 17 in particular in that, according to Figure 18, both undercuts 136, 136 of Figure 16 in laser protection structure 102 and of Figure 17 in stack 104 are present. Thus, a double-concave undercut structure is obtained according to Figure 18. This structure is obtained by a removal of part of the material of laser protection structure 102 and of stack 104 during formation of cavity 110.

**Figure 19** illustrates a plan view of a component carrier 100 according to another exemplary embodiment of the invention. According to Figure 19, the laser protection structure 102 and the laser stop structure 118 thereunder form an annularly closed frame extending entirely along the edge region between bottom wall 112 and sidewall 114 of cavity 110. This provides a fully circumferential protection of stack 104 and laser stop structure 118 by laser protection structure 102 against damage during formation of cavity 110 by laser processing. The planar extension of the multilayer conductive structure 134 may entirely extend beyond the planar extension of the cavity 110.

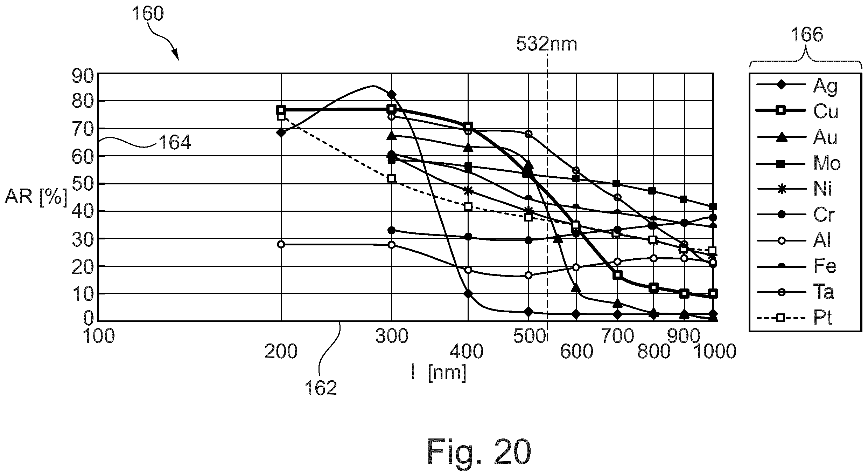

**Figure 20** is a diagram 160 showing a dependency between a wavelength λ of laser light, plotted along an abscissa 162, and an absorption rate AR, plotted along an ordinate 164 for different materials, which are indicated in a section 166.

For example, a pulsed picosecond laser operating at a wavelength in the range from 500 nm to 550 nm, for instance at 532 nm, may be used for cavity formation. In particular suitable as a material for laser protection structure 102 are all materials which are, for the used operating wavelength, below the line corresponding to copper being the material of electrically conductive laser stop structure 118. In the shown embodiment of a wavelength of 532 nm, particularly suitable materials for laser protection structure 102 are silver, aluminum, chromium. However, other materials may be appropriate at other operating wavelengths.

More generally, different laser types may be used having a different wavelength. Furthermore, every combination of material is possible provided that the laser protection structure 102 has a lower absorption rate than the laser stop layer 118. For example, at a wavelength of 200 nm, the laser protection structure 102 may be made of aluminum and the laser stop structure 118 may be made of silver. In another example, at a wavelength of 600 nm, the laser protection structure may be made of gold and the laser stop structure 118 may be made of nickel.

It should be noted that the term "comprising" does not exclude other elements or steps and the "a" or "an" does not exclude a plurality. Also, elements described in association with different embodiments may be combined.

It should also be noted that reference signs in the claims shall not be construed as limiting the scope of the claims.

Implementation of the invention is not limited to the preferred embodiments shown in the figures and described above. Instead, a multiplicity of variants is possible which use the solutions shown and the principle according to the invention even in the case of fundamentally different embodiments.

## Claims

1. A component carrier (100), wherein the component carrier (100) comprises:
a stack (104) with at least one electrically conductive layer structure (106) and at least one electrically insulating layer structure (108);
a cavity (110) formed in the stack (104) and being delimited by a bottom wall (112) and a sidewall (114); and
an electrically conductive laser protection structure (102) at least in an edge region between the bottom wall (112) and the sidewall (114).

2. The component carrier (100) according to claim 1, comprising an electrically conductive laser stop structure (118) covering at least part of said bottom wall (112) and/or of said sidewall (114) and being at least partially covered by said laser protection structure (102).

3. The component carrier (100) according to claim 2, wherein the laser stop structure (118) forms part of the at least one electrically conductive layer structure (106) of the stack (104).

4. The component carrier (100) according to any of claims 2 to 3, wherein the laser stop structure (118) and the laser protection structure (102) form a multilayer conductive structure (134).

5. The component carrier (100) according to claim 4, wherein a first portion of the multilayer conductive structure (134) is exposed in the cavity (110) and a second portion of the multilayer conductive structure (134) is embedded in the stack (104).

6. The component carrier (100) according to claim 5, wherein the laser protection structure (102) is arranged in the second portion, in particular is arranged only in the second portion.

7. The component carrier (100) according to any of claims 1 to 6, wherein the electrically conductive laser protection structure (102) extends laterally beyond the bottom wall (112) of the cavity in the stack (104).

8. The component carrier (100) according to any of claims 1 to 7, wherein the sidewall (114) has an undercut (136) between the stack (104) and the electrically conductive laser protection structure (102).

9. The component carrier (100) according to any of claims 1 to 8, wherein the laser protection structure (102) is made of a material configured for reflecting laser light.

10. The component carrier (100) according to any of claims 1 to 9, wherein the laser protection structure (102) and/or the laser stop structure (118) forms an annularly closed frame, in particular extending entirely along said edge region.

11. The component carrier (100) according to any of claims 1 to 10, wherein the laser stop structure (118) forms an electrically conductive pattern covering a part of said bottom wall (112) and exposing another part of said bottom wall (112); in particular wherein the laser protection structure (102) covers only the upper main surface of the electrically conductive pattern in the edge region, and optionally covers only sidewalls of the electrically conductive pattern in the edge region.

12. The component carrier (100) according to any of claims 1 to 11, wherein the stack (104) comprises a core (130) and a layer build-up (132) on said core (130), and wherein the cavity (110) extends through the entire layer build-up (132) and partially into said core (130).

13. The component carrier (100) according to any of claims 1 to 12, comprising at least one component (126), in particular an optical connector, inserted at least partially in at least part of said cavity (110).

14. A method of manufacturing a component carrier (100), wherein the method comprises:
providing a stack (104) with at least one electrically conductive layer structure (106) and at least one electrically insulating layer structure (108);
forming a cavity (110) in the stack (104), said cavity (110) being delimited by a bottom wall (112) and a sidewall (114); and
forming an electrically conductive laser protection structure (102) at least in an edge region between the bottom wall (112) and the sidewall (114), said laser protection structure (102) forming part of the readily manufactured component carrier (100).

15. The method according to claim 14, wherein the method comprises forming the cavity (110) by processing the stack (104) with a laser beam during which the laser protection structure (102) protects against the laser beam a layer structure (106, 108) of the stack (104), in particular an electrically conductive laser stop structure (118) arranged on the bottom wall (112) of the cavity (110).
